# EUROPÄISCHE PATENTANMELDUNG

(11) **EP 3 937 259 A1**
(43) Veröffentlichungstag der Anmeldung: **12.01.2022**
(21) Anmeldenummer: 20000251.7
(22) Anmeldetag: 10.07.2020
(51) Int. Cl.: H01L 31/041, H01L 31/0687, H01L 31/068, H01L 31/0304

(54) **MONOLITHISCHE METAMORPHE MEHRFACHSOLARZELLE**

(71) Anmelder: AZUR SPACE Solar Power GmbH, 74072 Heilbronn (DE)
(72) Erfinder: Meusel, Matthias, 74076 Heilbronn (DE); Berg, Alexander, 74074 Heilbronn (DE); Schroth, Philipp, 76684 Eichelberg (DE); Schreier, Susanne, 74354 Besigheim (DE)
(74) Vertreter: Koch Müller Patentanwaltsgesellschaft mbH

(57) **Zusammenfassung**

Monolithische Metamorphe Mehrfachsolarzelle umfassend eine erste III-V Teilzelle und eine zweite III-V Teilzelle und eine dritte III-V Teilzelle und eine vierte Ge-Teilzelle, wobei die Teilzellen in der angegebenen Reihenfolge aufeinandergestapelt sind, und die erste Teilzelle die oberste Teilzelle ausbildet und zwischen der dritten Teilzelle und der vierten Teilzelle ein metamorpher Puffer ausgebildet ist und alle Teilzellen jeweils eine n-dotierten Emitterschicht und eine p-dotierte Basisschicht aufweisen und bei der zweiten Teilzelle die Emitterschicht größer ist als die Basisschicht.

## Beschreibung

Die Erfindung betrifft eine monolithische metamorphe Mehrfachsolarzelle. Derartige Mehrfachsolarzellen werden vorzugsweise im Weltraum oder in terrestrischen Konzentratorphotovoltaiksystemen (CPV) eingesetzt. Hierbei sind wenigstens drei oder mehr Teilzellen mit unterschiedlichen Bandlücken mittels Tunneldioden aufeinandergestapelt.

Die Herstellung einer Vierfach-Solarzelle mit einer Teilzelle aus GaInAsP ist aus der Druckschrift "Wafer bonded four-junction GaInP/GaAs/GaInAsP/ GaInAs concentrator solar cells with 44.7% efficiency" von Dimroth et al. in Progr. Photovolt: Res. Appl. 2014; 22: 277-282, bekannt. In der genannten Druckschrift wird ausgehend von einem InP Substrat eine GaInAsP Solarzelle mit einer Energiebandlücke von ca. 1,12 eV gitterangepasst abgeschieden.

Die oberen Teilzellen mit höherer Bandlücke werden in einer zweiten Abscheidung in invertierter Reihenfolge auf einem GaAs Substrat hergestellt. Die Bildung der gesamten Mehrfach-Solarzelle geschieht durch einen direkten Halbleiterbond der beiden Epitaxiewafer, mit einer anschließenden Entfernung des GaAs Substrates und weiteren Prozessschritten. Der Herstellungsprozess ist jedoch sehr aufwändig und kostenintensiv.

Aus EP 2 960 950 A1 und EP 3 179 521 A1 sind weitere Mehrfach-Solarzellen mit GaInAsP Teilzelle bekannt. Des Weiteren sind aus der US 2018 0226 528 A1, der US 2017 0054 048 A1, der DE 10 2018 203 509 A1 und der US 2020 0027 999 A1 aufrecht gewachsene Mehrfachzellen mit unter anderem einem metamorphen Puffer bekannt.

Die Optimierung der Strahlungshärte, insbesondere auch für sehr hohe Strahlungsdosen, ist ein wichtiges Ziel bei der Entwicklung von Raumfahrtsolarzellen. Ziel ist es neben der Steigerung des Anfangs- bzw. beginning-of-life (BOL) Wirkungsgrades auch den end-of-life (EOL) Wirkungsgrades zu erhöhen.

Weiterhin sind die Herstellungskosten von entscheidender Bedeutung. Der industrielle Standard zum derzeitigen Zeitpunkt ist durch gitterangepasste Drelfach-Solarzellen und die metamorphe GaInP/GaInAs/Ge Dreifach-Solarzellen gegeben.

Vor diesem Hintergrund besteht die Aufgabe der Erfindung darin, eine Vorrichtung anzugeben, die den Stand der Technik weiterbildet.

Die Aufgabe wird durch eine monolithische metamorphe Mehrfachsolarzelle mit den Merkmalen des Patentanspruchs 1 gelöst. Vorteilhafte Ausgestaltungen der Erfindung sind Gegenstand von Unteransprüchen.

In dem Gegenstand der Erfindung wird eine monolithische Mehrsolarzelle umfassend eine erste III-V Teilzelle und eine zweite III-V Teilzelle und eine dritte III-V Teilzelle und eine vierte Ge-Teilzelle bereitgestellt.

Die Teilzellen sind in der angegebenen Reihenfolge aufeinandergestapelt.

Die erste Teilzelle bildet die oberste Teilzelle aus.

Zwischen der dritten Teilzelle und der vierten Teilzelle ist ein metamorpher Puffer ausgebildet.

Alle Teilzellen weisen jeweils eine n-dotierte Emitterschicht und eine p-dotierte Basisschicht auf.

Auch sei angemerkt, dass unter den Begriffen Emitter und Basis entweder die n-dotierten oder die p-dotierten die Schichten in der jeweiligen Teilzelle verstanden werden, anders ausgedrückt die Emitterschicht und die Basisschicht.

In einer Ausführungsform ist jeweils die oberste Schicht einer Teilzelle, d.h. vorliegend die Emitterschicht als n-Schicht ausgebildet. Hierdurch durchläuft das Licht in einer Teilzelle immer zuerst die Emitterschicht und anschließend die Basisschicht.

Bei der ersten, dritten und vierten Teilzelle ist die Emitterschicht um ein Vielfaches dünner als die Basisschicht. Bei der zweiten Teilzelle ist die Dicke der Emitterschicht hingegen größer ist als die Dicke der Basisschicht.

Bei den bisherigen Mehrfachsolarzellen, insbesondere in dem Bereich der Mehrfachsolarzellen, ist der Ansatz überraschend. Grund hierfür besteht darin, dass die Mobilität der Minoritäten in der n-dotierten Emitterschicht, also der Löcher, ca. eine Größenordnung niedriger ist als die der Elektronen. Ein weiterer Grund besteht in der Degradation der Minoritätsladungsträgerlebensdauer in den Basis- und Emitterschichten während der Anwendung aufgrund der einfallenden Weltraumstrahlung.

Des Weiteren sei angemerkt, dass mit dem metamorphen Puffer die Gitterkonstantenunterschiede zwischen der vierten Zelle und der dritten Zelle ausgeglichen werden. Der metamorphe Puffer besteht hierbei aus wenigstens drei III-V Schichten. Es handelt sich bei der beschriebenen Mehrfachsolarzelle um eine sogenannte aufrecht gewachsene Mehrfachsolarzelle einer sogenannten UMM (upright metamorphic multijunction) Mehrfachsolarzelle.

Ein Vorteil ist, dass die beschriebene Vorrichtung in überraschender Weise eine geringere Degradation zeigt. Anders ausgedrückt, die Reduktion des Wirkungsgrades unter Bestrahlung reduziert sich weniger, d.h. der EOL (end of life) Wirkungsgrad steigt im Vergleich zu den bisherigen Werten an.

In einer Ausführungsform ist zwischen den vier Teilzellen kein Halbleiterbond ausgebildet, insbesondere umfasst ist, dass zwischen zwei beliebigen Teilzellen der Mehrfachsolarzelle auch kein direkter Halbleiterbond ausgebildet ist.

Indem die Mehrfachsolarzelle stapelförmig aus einem Stapel ausgebildet ist, versteht sich hierdurch, dass der Stapel der Mehrfachsolarzelle nicht aus zwei Teilstapeln ausgebildet ist, welche auf unterschiedlichen Substraten abgeschieden wurden und nachträglich über einen Halbleiterbond zusammengefügt sind. Insbesondere weist der Solarzellenstapel keine amorphen Zwischenschichten auf, wie sie beim Bonden entstehen können.

Es wird angemerkt, dass das Sonnenlicht immer zuerst durch die oberste Teilzelle mit der größten Bandlücke eingestrahlt wird. Anders ausgedrückt, der Solarzellenstapel absorbiert mit der obersten Teilzelle zuerst den kurzwelligen Anteil des Lichtes. Die Bandlücke nimmt von der ersten Teilzelle hin zu vierten Teilzelle ab, wobei die Bandlücke der vierten Teilzelle ca. 0,67 eV beträgt.

Vorliegend durchströmen die Photonen also zuerst die erste Teilzelle und anschließend die zweite Teilzelle und anschließend die dritte Teilzelle und zuletzt die vierte Teilzelle. Vorzugsweise ist jeweils zwischen zwei unmittelbar aufeinanderfolgenden Teilzellen eine Tunneldiode ausgebildet.

In einem Ersatzschaltbild sind die einzelnen Teilzellen der Mehrfachsolarzelle als p/n Dioden mit dazwischenliegenden Tunneldioden als in Serie verschaltet aufzufassen. Hierdurch wirkt diejenige Teilzelle mit dem geringsten Strom limitierend, anders ausgedrückt, es ist vorteilhaft die einzelnen Teilzellen zueinander stromanzupassen.

In einer Weiterbildung ist bei der zweiten Teilzelle die Dicke der Emitterschicht größer als 600 nm.

Eigene Untersuchungen zeigten überraschenderweise, dass die Degradation der Ladungsträger-Lebensdauer in p-InGaAsP im genannten Kompositionsbereich unter Elektronenbestrahlung wider Erwarten hoch ist. Umso erstaunlicher ist es, das im Falle von n-dotierten InGaAsP eine sehr geringe Degradation gefunden wurde.

In einer Ausführungsform weist bei der zweiten Teilzelle die Basisschicht eine Dicke kleiner 450 nm und/oder eine Dotierung größer 4•17/cm^{s} auf. Alternativ weist die Basisschicht bei der zweiten Teilzelle eine Dicke kleiner 200 nm und/oder eine Dotierung größer als 8•17/cm³ auf.

In einer Weiterbildung umfasst die Emitterschicht der zweiten Teilzelle (SC2) InGaAsP oder besteht aus InGaAsP.

Es sei angemerkt, dass unter dem Begriff vorliegend die chemischen Abkürzungen von Elementen synonym zu den vollständigen Begriffen verwendet werden.

In einer Ausführungsform weist die Emitterschicht der zweiten Teilzelle einen Arsengehalt bezogen auf die Elemente der V-Hauptgruppe zwischen 22% und 33% und einen Indiumgehalt bezogen auf die Elemente der III-Hauptgruppe zwischen 52% und 65% auf. In einer Weiterbildung liegt die Gitterkonstante der Basisschicht zwischen 0,572 nm und 0,577 nm.

Es versteht sich, dass insbesondere der angegebene Arsen-Gehalt auf den Gesamtgehalt der Gruppe-V Atome bezogen ist. Entsprechend ist der angegebene Indium-Gehalt auf den Gesamtgehalt der Gruppe-III Atome bezogen. D.h. bei der Verbindung Ga_{1-X}In_{X}As_{Y}P_{1-Y} beträgt der Indium-Gehalt den Wert X und der Arsen-Gehalt den Wert Y und hierdurch ergibt sich für einen Arsen-Gehalt von z.B. 25% ein Y-Wert von 0,25.

Untersuchungen haben überraschender Welse ergeben, dass sich InGaAsP im genannten Kompositionsbereich mittels MOVPE mit überraschend guter Qualität abscheiden lässt. Hierdurch wird das Vorurteil überwunden, dass sich InGaAsP im genannten Kompositionsbereich, der innerhalb der Mischungslücke liegt, nicht mit der für Solarzellen notwendigen Qualität abscheidbar ist.

Dies ist umso überraschender, da eigene Untersuchungen zeigen, dass mit MOVPE abgeschiedenes InGaAsP in anderen Kompositionsbereichen sehr wohl die in der Literatur zu findende Mischungslücke bzw. Entmischung aufweist. D.h. in dem genannten Kompositionsbereich scheinen besondere Effekte vorzuliegen, welche eine Entmischung verhindern bzw. mildern.

In einer Weiterbildung ist oberhalb der Schicht der zweiten Teilzelle und unterhalb der ersten Teilzelle eine Passivierungsschicht aus einer Verbindung mit wenigstens den Elementen GaInP oder mit wenigstens den Elementen AlInP angeordnet. Anders ausgedrückt, die Passivierungsschicht Ist zwischen der ersten Teilzelle und der zweiten Teilzelle ausgebildet.

In einer anderen Weiterbildung unterscheidet sich die Gitterkonstante der ersten Teilzelle von der Gitterkonstante der dritten Teilzelle um weniger als 0,3% oder weniger als 0,2 %. Anders ausgedrückt die dritte Teilzelle und die zweite Teilzelle und die erste Teilzelle sind zueinander gitterangepasst.

In einer anderen Weiterbildung ist unterhalb der Schicht der zweiten Teilzelle und oberhalb des metamorphen Puffers eine Passivierungsschicht aus einer Verbindung mit wenigstens den Elementen GaInP oder mit wenigstens den Elementen AlInP angeordnet.

In einer Ausführungsform weist die zweite Teilzelle und / oder die weiteren Teilzellen keine Vielfach-Quantentopf-Struktur auf.

In einer Ausführungsform ist die zweite Teilzelle SC2 als Homozelle ausgebildet. Hierbei wird unter dem Begriff der Homozelle eine Zelle verstanden, bei der die Emitterschicht die gleichen Elemente mit der gleichen Stöchiometrie wie die Basisschicht aufweist.

In einer Weiterbildung umfasst oder besteht die Emitterschicht und die Basisschicht der zweiten Teilzelle jeweils aus InGaAsP.

In einer Ausführungsform ist die die zweite Teilzelle als Heterozelle ausgebildet. Vorzugsweise umfasst oder besteht die Emitterschicht der zweiten Teilzelle InGa(As)P oder aus InGa(As)P. Die Basisschicht umfasst InGaP oder AlInGaP oder InAlP oder AlInAs oder besteht oder aus InGaP oder aus AlInGaP oder aus InAlP oder aus AlInAs.

In einer anderen Weiterbildung ist bei der zweiten Teilzelle SC2 unterhalb der Basisschicht in Richtung zu der dritten Teilzelle SC3 eine Passivierungsschicht aus AlInAs oder AlInGaAs angeordnet.

In einer Ausführungsform ist bei der zweiten Teilzelle die Emitterdotierung wenigstens um den Faktor 3 oder wenigstens um den Faktor 5 oder wenigstens um den Faktor 8 kleiner als die Basisdotierung.

In einer Weiterbildung weist die Emitterschicht der zweiten Solarzelle einen ersten Bereich und einen zweiten Bereich auf, wobei der erste Bereich eine andere Größe der Dotierung als der zweite Bereich aufweist und der zweite Bereich näher an der Basis als der erste Bereich ausgebildet ist.

Vorzugsweise steigt die Dotierung im ersten Bereich in Richtung der ersten Solarzelle um mehr als 3•10¹⁷/cm³ an.

In einer Weiterbildung weist der zweite Bereich der zweiten Solarzelle eine Dicke größer als 150 nm und eine Dotierung kleiner als 1•10¹⁶/cm³ auf.

Alternativ weist der der zweite Bereich eine Dicke größer als 250 nm und eine Dotierung kleiner als 5•10¹⁵/cm³ auf.

In einer weiteren Ausführungsform weist bei der zweiten Teilzelle der untere Bereich in Richtung der dritten Teilzelle eine Dicke größer 150nm und / oder eine Dotierung kleiner 1•10¹⁶/cm³ auf. Alternativ weist bei der zweiten Teilzelle der untere Bereich der Emitterschicht in Richtung der dritten Teilzelle eine Dicke größer 250nm und eine Dotierung kleiner 5•10¹⁵/cm³ auf.

In einer Weiterbildung weist die Basisschicht der zweiten Teilzelle zumindest teilweise die Dotierstoffe Zn oder C oder Mg auf. Vorzugsweise weist die Emitterschicht zumindest teilweise die Dotierstoffe Si oder Te oder Se oder Ge auf.

In einer Weiterbildung ist bei der zweiten Teilzelle die Basisschicht mit Kohlenstoff dotiert. Alternativ ist die Kohlenstoffkonzentration in der Basisschicht höher als die Zink-Konzentration.

In einer Weiterbildung weist die erste Teilzelle einen größeren Bandabstand als die zweite Teilzelle auf. Die zweite Teilzelle weist einen größeren Bandabstand als die dritte Teilzelle auf. Die dritte Teilzelle weist einen größeren Bandabstand als die vierte Teilzelle auf.

Vorzugsweise weist die erste Teilzelle einen Bandabstand in einem Bereich zwischen 1,85 eV und 2,07 eV auf und die zweite Teilzelle einen Bandabstand in einem Bereich zwischen 1,41 eV und 1,53 eV auf und die dritte Teilzelle einen Bandabstand in einem Bereich zwischen 1,04 eV und 1,18 eV auf.

In einer Ausführungsform weist die erste Teilzelle eine Verbindung aus wenigstens den Elementen AlInP auf. Der Indium-Gehalt liegt bezogen auf die Elemente der III-Hauptgruppe zwischen 64% und 75% und der Al-Gehalt liegt zwischen 18% und 32%.

In einer Weiterbildung weist die dritte Teilzelle eine Verbindung aus wenigstens den Elementen InGaAs auf. Der Indium-Gehalt bezogen auf die Elemente der III-Hauptgruppe liegt oberhalb von 17 %.

In einer Weiterbildung ist zwischen der dritten Teilzelle und der vierten Teilzelle ein Halbleiterspiegel angeordnet. Durch den Einbau eines Halbleiterspiegels verringert sich die Dicke der Basisschicht im Vergleich zu der Dicke der Basisschicht ohne den Halbleiterspiegel in einem Bereich zwischen 50% und 90%.

In einer Ausführungsform ist oberhalb der Schicht der zweiten Teilzelle und unterhalb der ersten Teilzelle eine Passivierungsschicht aus einer Verbindung mit wenigstens den Elementen GaInP oder mit wenigstens den Elementen AlInAs oder mit wenigstens den Elementen AlInP angeordnet.

In einer Ausführungsform ist unterhalb der Schicht der zweiten Teilzelle und oberhalb des metamorphen Puffers eine Passivierungsschicht aus einer Verbindung mit wenigstens den Elementen GaInP oder mit wenigstens den Elementen AlInP angeordnet.

In einer Ausführungsform sind genau vier Teilzellen oder genau fünf Teilzellen vorgesehen, wobei bei einer Mehrfachsolarzelle mit fünf Teilzellen eine fünfte Teilzelle zwischen der ersten Teilzelle und der zweiten Teilzelle ausgebildet ist.

Es versteht sich, dass die fünfte Teilzelle eine größere Bandlücke als die zweite Teilzelle und eine kleinere Bandlücke als die erste Teilzelle aufweist. Die fünfte Teilzelle ist zur zweiten Teilzelle gitterangepasst.

Vorzugsweise ist bei der fünften Teilzelle die Dicke der Emitterschicht kleiner als die Dicke der Basisschicht.

In einer Weiterbildung weist bei der zweiten Teilzelle die Emitterschicht einen Antimon-Gehalt kleiner 1% auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine erste Ausführungsform einer monolithischen metamorphen Mehrfachsolarzelle,
- Figur 2: eine Ansicht auf eine zweite Ausführungsform einer monolithischen metamorphen Mehrfachsolarzelle,
- Figur 3: eine Ansicht auf eine dritte Ausführungsform einer monolithischen metamorphen Mehrfachsolarzelle.
Die Abbildung der Figur 1 zeigt eine erste Ausführungsform einer monolithischen metamorphen Mehrfachsolarzelle mit einer ersten oberen Teilzelle SC1 auf einer darunterliegenden zweiten Teilzelle SC2. Bei Bestrahlung trifft das Licht L zuerst auf die Oberseite der ersten Teilzelle SC1

Zwischen der ersten Teilzelle SC1 und der zweiten Teilzelle SC2 ist eine obere Tunneldiode TD1 ausgebildet.

Unterhalb der zweiten Teilzelle SC2 ist eine dritte Teilzelle SC3 angeordnet. Zwischen der zweiten Teilzelle SC2 und der dritten Teilzelle SC3 ist eine zweite Tunneldiode TD2 ausgebildet.

Unterhalb der dritten Teilzelle SC3 ist eine vierte Teilzelle SC4 angeordnet. Zwischen der dritten Teilzelle SC3 und der vierten Teilzelle SC4 ist eine dritte Tunneldiode TD3 ausgebildet.

Zwischen der vierten Teilzelle SC4 und der dritten Tunneldiode TD3 ist ein metamorpher Puffer MP angeordnet.

Jede der Teilzellen SC1, SC2, SC3 und SC4 weist eine n-dotierte Emitterschicht stoffschlüssig aufliegend auf einer p-dotierten Basisschicht auf.

Die Dicke der Emitterschicht bei der ersten, dritten und vierten Teilzelle SC1, SC3, SC4 ist jeweils kleiner als die Dicke der zugehörigen Basisschicht.

Bei der zweiten Teilzelle SC2 ist die Dicke der Emitterschicht größer als die Dicke der Basisschicht.

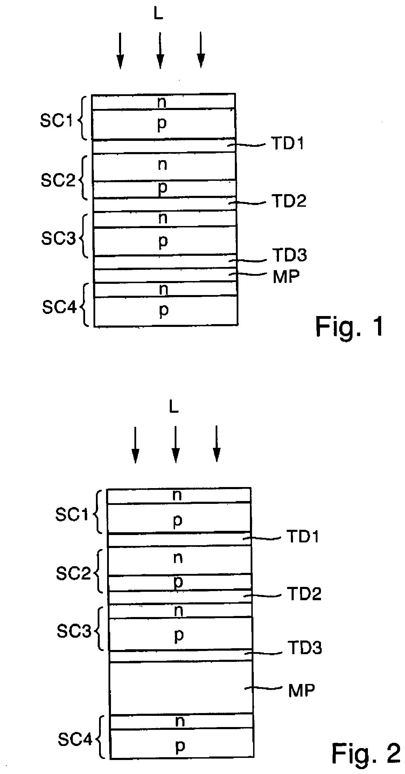

Die Abbildung der Figur 2 zeigt eine zweite Ausführungsform einer Vierfach-solarzelle. Im Folgenden werden nur die Unterschiede zu der ersten Ausführungsform erläutert.

Die zweite Teilzelle SC2 weist einen Emitter aus InGaP und eine Basis aus InGaAsP auf, d.h. der Emitter weist eine ternäre Verbindung im Gegensatz zu der quaternären Verbindung in der Basis auf. Hierdurch ist die zweite Teilzelle SC2 als sogenannte Heterozelle ausgebildet.

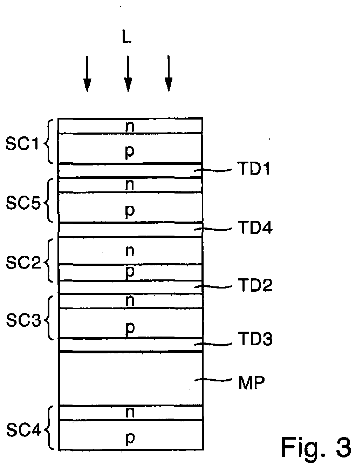

Die Abbildung der Figur 3 zeigt eine dritte Ausführungsform einer Vierfach-solarzelle. Im Folgenden werden nur die Unterschiede zu den vorangegangenen Ausführungsformen erläutert.

Zwischen der ersten Teilzelle SC1 und der zweiten Teilzelle SC2 ist eine fünfte Teilzeile SC5 angeordnet. Zwischen der fünften Teilzelle SC5 und der zweiten Teilzelle SC2 ist eine vierte Tunneldiode TD4 angeordnet. Die fünfte Teilzelle SC5 ist zu der zweiten Teilzelle als auch zu der dritten Teilzelle gitterangepasst.

## Patentansprüche

1. Monolithische metamorphe Mehrfachsolarzelle umfassend
- eine erste III-V Teilzelle (SC1)
- eine zweite III-V Teilzelle (SC2),
- eine dritte III-V Teilzelle (SC3),
- eine vierte Ge-Teilzelle (SC4), die Teilzellen (SC1, SC2, SC3, SC4) in der angegeben Reihenfolge aufeinandergestapelt sind, und die erste Teilzelle (SC1) die oberste Teilzelle ausbildet
- zwischen der dritten Teilzelle (SC3) und der vierten Teilzelle (SC4) ein metamorpher Puffer (MP1) ausgebildet ist,
- alle Teilzellen (SC1, SC2, SC3, SC4) jeweils einen n-dotierten Emitterschicht und eine p-dotierte Basisschicht aufweisen,
- die Dicke der Emitterschicht bei der ersten, dritten und vierten Teilzelle (SC1, SC3, SC4) jeweils kleiner ist als die Dicke der zugehörigen Basisschicht
**dadurch gekennzeichnet, dass**
bei der zweiten Teilzelle (SC2) die Dicke der Emitterschicht größer ist als die Dicke der Basisschicht.

2. Monolithische metamorphe Mehrfachsolarzelle nach Anspruch 1, **dadurch gekennzeichnet, dass** die Dicke der Emitterschicht eine Dicke größer als 600 nm aufweist.

3. Monolithische metamorphe Mehrfachsolarzelle nach Anspruch 1 oder Anspruch 2, **dadurch gekennzeichnet, dass** die Basisschicht eine Dicke kleiner 450 nm und/oder eine Dotierung größer 4•10¹⁷/cm³ aufweist.

4. Monolithische metamorphe Mehrfachsolarzelle nach einem der vorstehenden Ansprüche, **dadurch gekennzeichnet, dass** bei der zweiten Teilzelle (SC2) die Emitterschicht InGaAsP umfasst oder aus InGaAsP besteht.

5. Monolithische metamorphe Mehrfachsolarzelle nach Anspruch 4, **dadurch gekennzeichnet, dass** bei der zweiten Teilzelle (SC2) die Emitterschicht einen Arsengehalt bezogen auf die Elemente der V-Hauptgruppe zwischen 22% und 33% und einen Indiumgehalt bezogen auf die Elemente der III-Hauptgruppe zwischen 52% und 65% aufweist, und die Gitterkonstante der Emitterschicht zwischen 0,572 nm und 0,577 nm liegt.

6. Monolithische metamorphe Mehrfachsolarzelle nach einem der vorangegangenen Ansprüche, **dadurch gekennzeichnet, dass** die zweite Teilzelle (SC2) als Heterozelle ausgebildet ist.

7. Monolithische metamorphe Mehrfachsolarzelle nach einem der vorstehenden Ansprüche, **dadurch gekennzeichnet, dass** bei der zweiten Teilzelle (SC2) die Basisschicht InGaAsP oder InGaP oder AlInGaP oder InAlP oder AlInAs umfasst oder aus InGaAsP oder aus InGaP oder aus AlInGaP oder aus InAlP oder aus AlInAs besteht.

8. Monolithische metamorphe Mehrfachsolarzelle nach einem der vorstehenden Ansprüche, **dadurch gekennzeichnet, dass** die erste Teilzelle (SC1) einen Bandabstand in einem Bereich zwischen 1,85 eV und 2,07 eV aufweist und die zweite Teilzelle (SC2) einen Bandabstand in einem Bereich zwischen 1,41 eV und 1,53 eV aufweist und die dritte Teilzelle (SC3) einen Bandabstand in einem Bereich zwischen 1,04 eV und 1,18 eV aufweist.

9. Monolithische metamorphe Mehrfachsolarzelle nach einem der vorstehenden Ansprüche, **dadurch gekennzeichnet, dass** die erste Teilzelle (SC1) eine Verbindung aus wenigstens des Elementen AlInP aufweist und der Indium-Gehalt bezogen auf die Elemente der III-Hauptgruppe zwischen 64% und 75% und der Al-Gehalt zwischen 18% und 32% liegt.

10. Monolithische metamorphe Mehrfachsolarzelle nach einem der vorstehenden Ansprüche, **dadurch gekennzeichnet, dass** ein Halbleiterspiegel (HS) zwischen der dritten Teilzelle (SC3) und der vierten Teilzelle (SC4) angeordnet ist.

11. Monolithische metamorphe Mehrfachsolarzelle nach einem der vorangegangenen Ansprüche **dadurch gekennzeichnet, dass** bei der zweiten Teilzelle (SC2) die Emitterschicht wenigstens teilweise eine Dotierstoffgradienten aufweist und die Dotierstoffkonzentration in Richtung der ersten Teilzelle (SC1) auf mehr als 3•10¹⁷/cm³ ansteigt.

12. Monolithische metamorphe Mehrfachsolarzelle nach einem der vorangegangenen Ansprüche **dadurch gekennzeichnet, dass** die Emitterschicht der zweiten Teilzelle (SC2) einen ersten Bereich und einen zweiten Bereich aufweist, wobei der erste Bereich eine andere Größe der Dotierung als der zweite Bereich aufweist und der zweite Bereich näher an der Basis als der erste Bereich ausgebildet ist.

13. Monolithische metamorphe Mehrfachsolarzelle nach einem der vorangegangenen Ansprüche **dadurch gekennzeichnet, dass** genau vier Teilzellen oder genau fünf Teilzellen vorgesehen sind, wobei zwischen der erste Teilzelle (SC1) und der zweiten Teilzelle (SC2) eine fünfte Teilzelle (SC5) ausgebildet ist.

14. Monolithische metamorphe Mehrfachsolarzelle nach einem der vorstehenden Ansprüche, **dadurch gekennzeichnet, dass** bei der zweiten Teilzelle (SC2) die Basisschicht mit Kohlenstoff dotiert ist und/oder dass die Kohlenstoffkonzentration in der Basisschicht der zweiten Solarzelle höher ist als die Zink-Konzentration.

15. Monolithische metamorphe Mehrfachsolarzelle nach einem der vorstehenden Ansprüche, **dadurch gekennzeichnet, dass** bei der zweiten Teilzelle (SC2) die Emitterdotierung wenigstens um den Faktor 3 kleiner ist als die Basisdotierung.
